# EUROPÄISCHE PATENTSCHRIFT

(11) **EP 4 512 220 B1**
(45) Veröffentlichungstag und Bekanntmachung des Hinweises auf die Patenterteilung: **07.10.2026**
(21) Anmeldenummer: 24706987.5
(22) Anmeldetag: 21.02.2024
(51) Int. Cl.: H05K 7/20

(54) **VERFAHREN UND VORRICHTUNG ZUR ABDICHTUNG EINER DICHTSTELLE IN EINEM HYBRID-KÜHLBAUTEIL**
METHOD AND DEVICE FOR SEALING A SEALING POINT IN A HYBRID COOLING DEVICE
PROCÉDÉ ET DISPOSITIF POUR L'ÉTANCHÉIFICATION D'UN POINT D'ÉTANCHÉITÉ DANS UN DISPOSITIF DE REFROIDISSEMENT HYBRIDE

(30) Priorität: 21.02.2023 DE 102023104233
(43) Veröffentlichungstag der Anmeldung: 26.02.2025
(73) Patentinhaber: Erwin Quarder Systemtechnik GmbH, 32339 Espelkamp (DE)
(72) Erfinder: HEITBRINK, Alexander, 32351 Stemwede (DE); SIEWERT, Georg, 35415 Pohlheim (DE)
(74) Vertreter: Geskes, Christoph
(86) Internationale Anmeldenummer: PCT/EP2024/054361
(87) Internationale Veröffentlichungsnummer: WO 2024/175630

(56) Entgegenhaltungen:
- EP-A1- 2 405 102
- US-A1- 2008 260 455
- US-A1- 2021 172 528
- US-A1- 2022 305 597
- US-A1- 2022 395 933
- US-B1- 6 699 540

## Beschreibung

Die vorliegende Erfindung betrifft ein Verfahren zur Abdichtung einer Dichtstelle in einem Hybrid-Kühlbauteil zum Abführen von Wärme von zu kühlenden Gegenständen, welche sich zwischen einer Kunststoffwandung eines ersten Bauteils und einer vorzugsweise mit dieser Kunststoffwandung insbesondere stoff- und/oder formschlüssig verbundenen Wandung aus einem metallischen Werkstoff, insbesondere Aluminium, eines zweiten Bauteils befindet. Sie betrifft des Weiteren eine Vorrichtung mit einem solchen ersten und zweiten Bauteil und einer solchen Dichtstelle.

Insbesondere, aber nicht nur für Vorrichtungen wie Kühleinrichtungen für Leitungselektronikbauteile werden mittlerweile auch bei Anwendungen, bei denen besondere Dichtigkeitserfordernisse erfüllt werden müssen, Kunststoff und Metallwerkstoff miteinander verbunden, um die spezifischen Vorteile des jeweiligen Werkstoffs miteinander kombinieren zu können.

Je nach Ausführung der jeweiligen Vorrichtung stellt sich dann häufig die Frage der ausreichend flüssigkeitsdichten Abdichtung zwischen diesen Werkstoffen.

US 2022/395933 A1 offenbart ein Verfahren zur Bildung einer hermetischen Druckpassung zwischen einem Bauteil und einem inneren Element. Das Verfahren umfasst die Schritte des Verbindens eines Bauteils mit einem anderen Bauteil durch Aufbringen von Wärme auf das erste Bauteil oder das zweite Bauteil oder auf mehrere davon und der Abkühlung des ersten Bauteils und des zweiten Bauteils, wobei der Schritt des Aufbringens von Wärme und des Abkühlens die hermetische Abdichtung durch Ausübung von Druck eines hermetischen Elements auf das zweite Bauteil und auf das innere Element bildet.

US 2022/305597 A1 offenbart ein Verfahren zur Herstellung eines hybriden Wärmetauschers. Das Verfahren umfasst eine Lasertexturierung einer Metalloberfläche, um eine Vielzahl von Mikrostrukturen zu erzeugen, und das anschließende Schmelzkleben einer Kunststoffkomponente mit der Vielzahl von Mikrostrukturen. Während des Schmelzklebens verbindet sich das Kunststoffteil mit der Metalloberfläche.

US 2008/260455A1 offenbart eine Verbunddichtung, bei der eine erste und eine zweite Metallschicht im Abstand übereinander liegen. Zwischen den Metallschichten befindet sich eine Mineralschicht. Die Metall- und Mineralschichten haben einen inneren und einen äußeren Umfang, wobei sich die inneren Umfänge überlappen, um eine Öffnung zu bilden. Die Metallschichten werden an einem Rand, vorzugsweise dem äußeren Rand, durch Schweißen verbunden. Bei den Metallschichten handelt es sich vorzugsweise um Folien aus Edelmetall oder Hochtemperaturlegierungen, und die Mineralschicht kann aus Glimmer, Vermiculit oder Modifikationen von Vermiculit bestehen.

EP 2 405 102 A1 offenbart eine Strömungsmaschine mit zwei Bauteilen, die über eine Balgdichtung miteinander in Zusammenwirkungung stehen, so dass die Balgdichtung eine Mediensperre zwischen zwei an die beiden Bauteile angrenzenden Räumen der Strömungsmaschine bildet.

US 6 699 540 B1 offenbart eine Dichtung, die auf einem Verbindungsabschnitt zwischen Auspuffrohren verschiebbar ist. Ein erstes Auspuffrohr mit einem kleinen Durchmesser und ein zweites Auspuffrohr mit einem großen Durchmesser sind so verschiebbar, dass ein Endabschnitt des ersten Auspuffrohrs in einen Endabschnitt des zweiten Auspuffrohrs eingeführt ist. Bei einer solchen Verbindungsstruktur der Auspuffrohre ist die Dichtung an der Außenseite eines Endabschnitts des ersten Auspuffrohrs angebracht und in den Innenraum eines Endabschnitts des zweiten Auspuffrohrs eingesetzt.

US 2021/0172528 A1 offenbart eine Dichtungsanordnung. In einem Beispiel umfasst die Dichtungsanordnung einen Verbunddichtungsring, der eine Dichtungsringhülle und einen Dichtungseinsatz, ein Außengehäuse, mindestens eine Feder und einen geschweißten Balg umfasst. Der geschweißte Balg kann ein festes Ende und ein gegenüberliegendes freies Ende aufweisen. Das feste Ende kann an die Dichtungsringhülle oder das Außengehäuse geschweißt sein, und das freie Ende kann eine nicht geschweißte Kontaktdichtung mit dem anderen Teil der Dichtungsringhülle oder dem Außengehäuse bilden.

Aufgabe der vorliegenden Erfindung ist es daher, das eingangs genannte Verfahren und die eingangs genannte Vorrichtung weiterzuentwickeln.

Diese Aufgabe wird gelöst durch ein Verfahren mit den Merkmalen des Anspruchs 1 sowie eine Vorrichtung mit den Merkmalen des Anspruchs 2.

Ein Dichtungssystem mit einem Dichtungsteil, mit einem ersten Bauteil und mit einem zweiten Bauteil weist ein flächiges, separates Dichtungsteil aus einem metallischen Werkstoff, bevorzugt aus Aluminium, das die Dichtstelle unter flüssigkeitsdichter Abdichtung derselben überdeckt, auf, wobei es einerseits mit der Kunststoffwandung des ersten Bauteils flüssigkeitsdicht verbunden ist, insbesondere stoffschlüssig, und andererseits mit der Wandung aus dem metallischen Werkstoff des zweiten Bauteils flüssigkeitsdicht verschweißt ist, bevorzugt laserverschweißt.

Unter "metallischem" Werkstoff werden Werkstoffe verstanden, bei denen mindestens eine Komponente aus Metall besteht. Dies können demnach unter anderem reine Metalle ein, aber auch Legierungen, wie etwa Stahl.

Die erfindungsgemäße Verwendung eines separaten Dichtungsteils aus einem solchen metallischen Werkstoff ermöglicht erfindungsgemäß, die jeweilige Dichtstelle in besonders zuverlässiger Weise flüssigkeitsdicht abzudichten, wobei das Dichtungsteil unter Nutzung geeigneter Verbindungsverfahren dann einerseits flüssigkeitsdicht mit der Kunststoffwandung verbunden ist und andererseits mit der Wandung aus dem metallischen Werkstoff flüssigkeitsdicht verschweißt ist.

Das Dichtungsteil kann vorteilhafterweise zumindest in einem Verformungsabschnitt eine Dicke aufweisen, die eine elastische Verformung desselben ermöglicht, die insbesondere material- und/oder konstruktionsbedingte Unterschiede im Wärmausdehnungsverhalten der Kunststoffwandung des ersten Bauteils und der Wandung aus dem metallischen Werkstoff des zweiten Bauteils ausgleichen kann.

Falls die Dichtstelle ein bevorzugt umlaufender Dichtspalt zwischen der Kunststoffwandung des ersten Bauteils und der Wandung aus dem metallischen Werkstoff des zweiten Bauteils ist, kann vorgesehen sein, dass das Dichtungsteil ein bevorzugt umlaufender Dichtungsrahmen ist, der den Dichtspalt unter Abdichtung desselben überdeckt, insbesondere derart, dass ein erster, insbesondere umlaufender Verbindungsabschnitt des Dichtungsteils mit dem ersten Bauteil flüssigkeitsdicht verbunden ist und ein zweiter, insbesondere umlaufender Verbindungsabschnitt des Dichtungsteils mit dem zweiten Bauteil.

Die beiden Verbindungsabschnitte des Dichtungsrahmens können sich vorzugsweise in unterschiedlichen Ebenen erstrecken und durch einen diese miteinander verbindenden Zwischenabschnitt miteinander verbunden sein, insbesondere durch den Verformungsabschnitt.

Was die flüssigkeitsdichte Verbindung zwischen dem Dichtungsteil einerseits und der Kunststoffwandung des ersten Bauteils andererseits betrifft, so kann diese umfassen, dass mindestens eine Verbindungsfläche der Kunststoffwandung des ersten Bauteils mit einer Verbindungsfläche des Dichtungsteils aus dem metallischen Werkstoff verpresst ist, insbesondere mit einer an dem ersten Verbindungsabschnitt angeordneten Verbindungsfläche, wobei diese Verbindungsfläche des Dichtungsteils über eine insbesondere mittels eines chemischen und/oder physikalischen Mikrostrukturierungsverfahrens in die Verbindungsfläche eingebrachte Nano- und/oder Mikrostrukturierung verfügt, insbesondere eine Nanound/oder Mikrostrukturierung, die eine Oberflächenvergrößerung bewirkt und/oder dreidimensionale, vorzugsweise Hinterschneidungen umfassende Vertiefungen und/oder Widerhaken aufweist.

Was des Weiteren die flüssigkeitsdichte Verbindung zwischen dem Dichtungsteil einerseits und der Wandung aus dem metallischen Werkstoff des zweiten Bauteils andererseits betrifft, so kann diese umfassen, dass mindestens eine Verbindungsfläche des Dichtungsteils mit einer Verbindungsfläche der Wandung aus dem metallischen Werkstoff des zweiten Bauteils durch Laserschweißen, insbesondere Laserdurchstrahlschweißen, verbunden ist.

Das erfindungsgemäße Verfahren gemäß Anspruch 1 zur flüssigkeitsdichten Abdichtung zwischen einer oder der Kunststoffwandung des ersten Bauteils und einer oder der Wandung aus dem metallischen Werkstoff des zweiten Bauteils umfasst zumindest folgende Maßnahmen:
a) Bearbeiten einer bzw. der ersten Verbindungsfläche eines bzw. des Dichtungsteils mit einem chemischen und/oder physikalischen Mikrostrukturierungsverfahren, so dass Nano- und/oder Mikrostrukturen in diese Verbindungsfläche eingebracht werden, insbesondere Nano- und/oder Mikrostrukturen, die eine Oberflächenvergrößerung bewirken und/oder Hinterschneidungen umfassende Vertiefungen aufweisen und/oder Widerhaken,
b) Flüssigkeitsdichtes Überdecken der Dichtstelle mit dem Dichtungsteil, wobei
   b1) eine oder die erste Verbindungsfläche des Dichtungsteils mit einer oder der Verbindungsfläche der Kunststoffwandung des ersten Bauteils flüssigkeitsdicht verpresst wird, und wobei
   b2) eine oder die zweite Verbindungsfläche des Dichtungsteils mit einer oder der Verbindungsfläche der Wandung aus dem metallischen Werkstoff des zweiten Bauteils flüssigkeitsdicht verschweißt wird, insbesondere mittels Laser.

Was die erfindungsgemäße Vorrichtung gemäß Anspruch 2 betrifft, so ist diese ein Hybrid-Kühlbauteil zum Abführen von Wärme von zu kühlenden Gegenständen, wie etwa von Leistungselektronikmodulen, durch das ein Kühlmedium leitbar ist, das die Abwärme abführen kann, wobei das erste Bauteil mit der Kunststoffwandung ein Grundkörper aus Kunststoff des Hybrid-Kühlbauteils ist sowie das zweite Bauteil mit der Wandung aus dem metallischen Werkstoff ein Kühlkörper aus einem metallischen Werkstoff des Hybrid-Kühlbauteils, an den zu kühlende Gegenstände anordenbar sind und der unter Bildung der von dem Dichtungsteil überdeckten, insbesondere einen vorzugsweise umlaufenden Spalt bildenden Dichtstelle mit dem Grundkörper aus Kunststoff insbesondere stoff- und/oder formschlüssig verbunden ist.

Dabei kann das Dichtungsteil ein insbesondere umlaufender, bevorzugt geschlossener Dichtungsrahmen sein, der den Dichtspalt überdeckt. Dies insbesondere derart, dass eine erste, insbesondere umlaufende, bevorzugt geschlossene Verbindungsfläche des Dichtungsrahmens, insbesondere ein Verbindungsstreifen, mit einer insbesondere umlaufenden Verbindungsfläche, insbesondere einem Verbindungsstreifen, der Kunststoffwandung des Grundkörpers des Hybrid-Kühlbauteils flüssigkeitsdicht verbunden ist und eine zweite, vorzugsweise umlaufende, bevorzugt geschlossene Verbindungsfläche des Dichtungsrahmens, insbesondere ein Verbindungsstreifen, mit einer insbesondere umlaufenden Verbindungsfläche des Kühlkörpers des Hybrid-Kühlbauteils.

Vorteilhafterweise kann die flüssigkeitsdichte Verbindung zwischen dem Dichtungsrahmen einerseits und der Kunststoffwandung des Grundkörpers andererseits umfassen, dass die Verbindungsfläche der Kunststoffwandung des Grundkörpers mit der ersten Verbindungsfläche des Dichtungsrahmens flüssigkeitsdicht verpresst ist, wobei die erste Verbindungsfläche des Dichtungsrahmens über eine insbesondere mittels eines chemischen und/oder physikalischen Mikrostrukturierungsverfahrens in die Verbindungsfläche eingebrachte Nanound/oder Mikrostrukturierung verfügt, insbesondere eine Nano- und/oder Mikrostrukturierung, die eine Oberflächenvergrößerung bewirkt und/oder Hinterschneidungen umfassende Vertiefungen und/oder Widerhaken aufweist.

In dem Hybrid-Kühlbauteil kann mindestens ein zu kühlender Gegenstand angeordnet sein, der mit dem Kühlkörper unter Anlage an diesen verbunden ist. Dies insbesondere, indem eine Außenseite des zu kühlenden Gegenstands, insbesondere aus einem metallischen Werkstoff, mit einer Seite des Kühlkörpers verschweißt ist.

Eine Seite des Kühlkörpers kann im Übrigen eine Begrenzungsfläche eines Kühlmediumkanals des Hybrid-Kühlbauteils bilden, durch den Kühlmedium zum Abtransport von Abwärme eines oder des zu kühlenden Gegenstands leitbar ist. Eine andere Seite des Kühlkörpers wiederum kann eine bzw. die Kühlfläche bilden, an der ein oder der zu kühlende Gegenstand anordenbar ist oder angeordnet ist, insbesondere unter Verschweißen der Außenseite des zu kühlenden Gegenstands mit dieser anderen Seite des Kühlkörpers.

Weiter kann vorgesehen sein, dass der Dichtungsrahmen einen ersten, vorzugsweise äußeren Randabschnitt aufweist, an dem die erste Verbindungsfläche angeordnet ist, und einen zweiten, vorzugsweise inneren Randabschnitt, an dem die zweite Verbindungsfläche angeordnet ist, und dass zwischen diesen beiden Randabschnitten ein Verformungsabschnitt des Dichtungsrahmens angeordnet ist, der eine Dicke aufweist, die eine elastische Verformung desselben ermöglicht, die insbesondere material- und/oder konstruktionsbedingte Unterschiede im Wärmausdehnungsverhalten der Kunststoffwandung des Grundkörpers und dem metallischen Werkstoff des Kühlkörpers ausgleichen kann.

Weitere Merkmale der vorliegenden Erfindung ergeben sich aus den beigefügten Patentansprüchen, der nachfolgenden Beschreibung eines bevorzugten Ausführungsbeispiels der Erfindung sowie aus den beigefügten Zeichnungen. Darin zeigt:

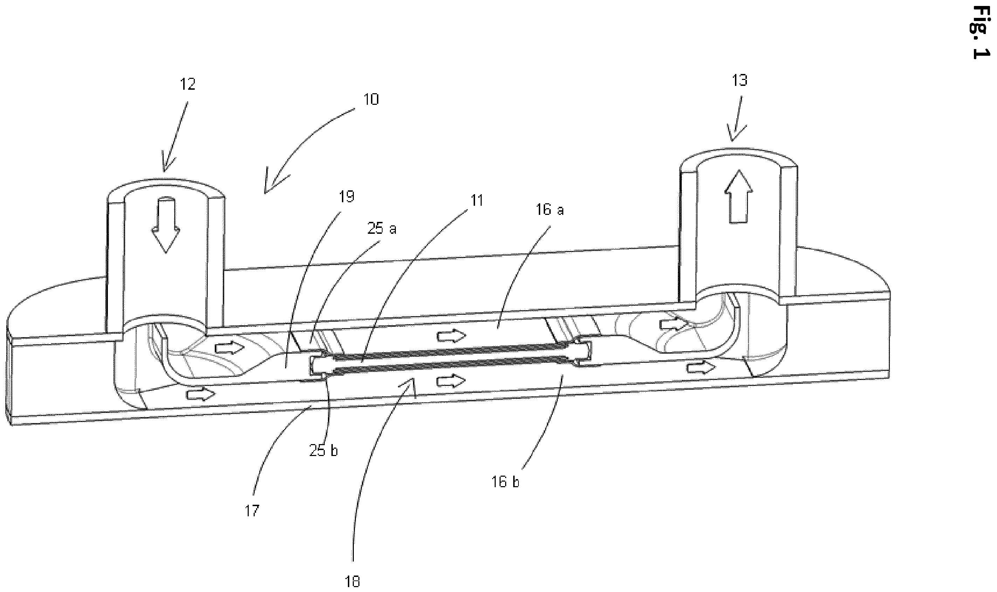

- Fig. 1: ein Hybrid-Kühlbauteil in Schrägansicht (teilweise geschnitten), bei dem eine Dichtstelle mit einem erfindungsgemäßen Dichtsystem abgedichtet ist,

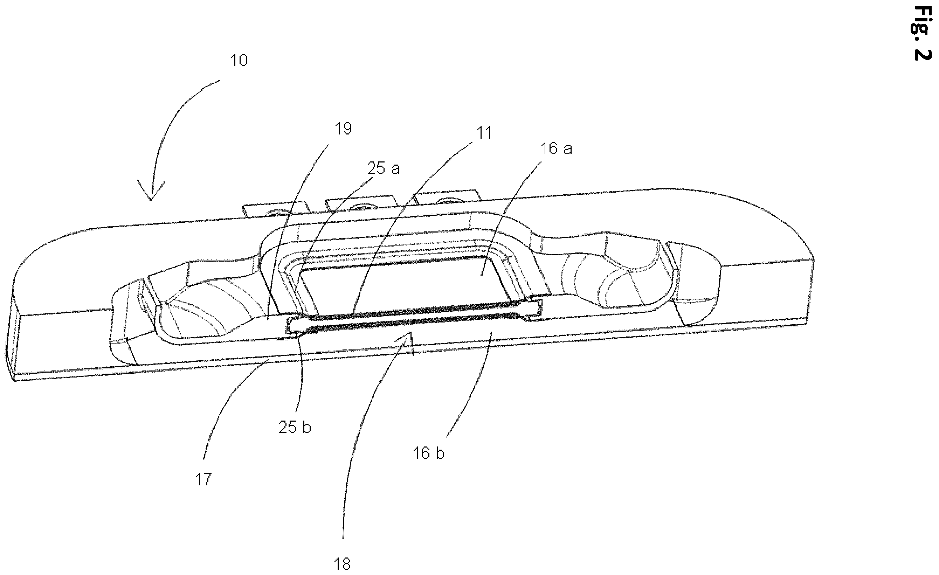

- Fig. 2: das Hybrid-Kühlbauteil aus Fig. 1, ebenfalls in Schrägansicht (teilweise geschnitten), wobei Einzelheiten weggelassen wurden,

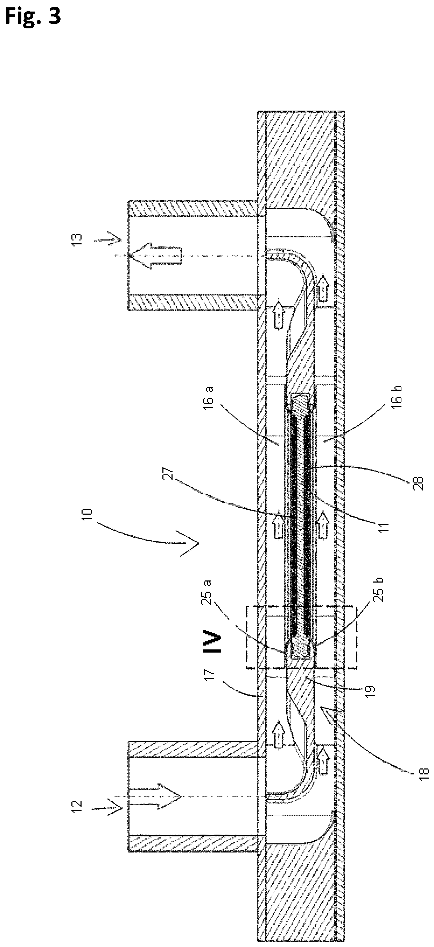

- Fig. 3: das Hybrid-Kühlbauteil aus Fig. 1 in einem Längsschnitt,

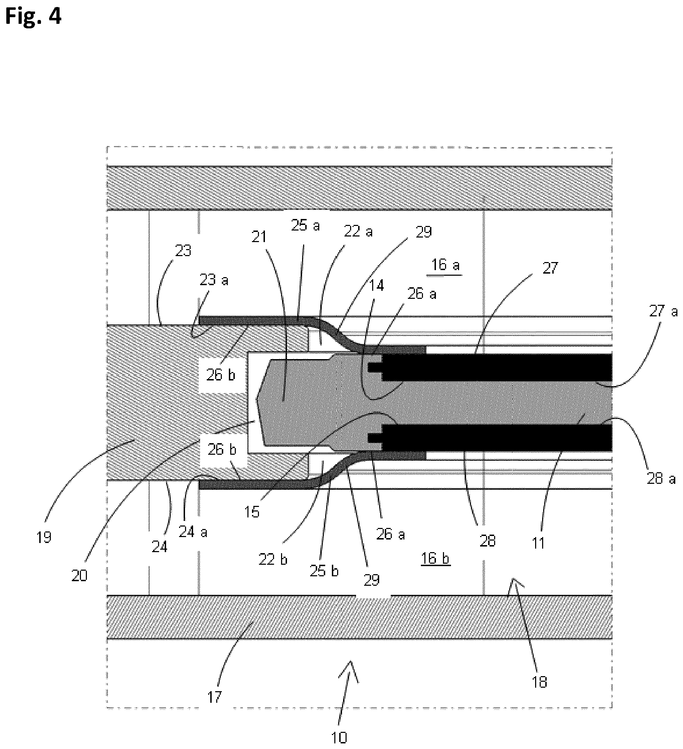

- Fig. 4: die Einzelheit IV in Fig. 3 in vergrößerter Darstellung.

Das Dichtungssystem wird anhand eines Hybrid-Kühlbauteils 10 erläutert, mit dem Wärme von zu kühlenden Gegenständen abgeleitet wird, indem durch das Hybrid-Kühlbauteil 10 von einer nicht dargestellten Kühlflüssigkeitsquelle stammendes Kühlmedium, insbesondere Kühlflüssigkeit, durch das Hybrid-Kühlbauteil 10 geleitet wird und Abwärme, die ein zu kühlender Gegenstand 11 abgibt, von dem Kühlmedium weg transportiert wird.

Das Hybrid-Kühlbauteil 10 umfasst vorliegend einen Zulauf 12, über den das Kühlmedium in das Hybrid-Kühlbauteil 10 geleitet wird, und einen Ablauf 13, über den Kühlmedium nach Aufnahme der Wärme des zu kühlenden Gegenstands 11 wieder aus dem Hybrid-Kühlbauteil 10 herausgeführt wird. Der zu kühlende Gegenstand 11 kann beispielsweise ein Leistungselektronikchip sein.

Im vorliegenden Fall soll sowohl die Oberseite 14 als auch die Unterseite 15 des zu kühlenden Gegenstands 11 gekühlt werden. Aus diesem Grund wird das Kühlmedium sowohl entlang der Oberseite 14 als auch der Unterseite 15 geführt, und zwar jeweils durch einen Kühlkanal 16 a bzw. 16 b des Hybrid-Kühlbauteils 10.

Das Hybrid-Kühlbauteil 10 umfasst im vorliegenden Fall einen spritzgegossenen Grundkörper 17 aus Kunststoff, der über verschiedene Wandungen verfügt und einen Innenraum 18 aufweist, in dem die Kühlkanäle 16 a bzw. 16 b ausgebildet sind sowie der zu kühlende Gegenstand 11 angeordnet ist.

Des Weiteren umfasst das Hybrid-Kühlbauteil 10 jeweils aus einem metallischen Werkstoff, insbesondere Aluminium, hergestellte bzw. bestehende, vorliegend in parallelen Ebenen angeordnete Kühlkörper 27 und 28, zwischen denen sich der zu kühlende Gegenstand 11 befindet, wobei der (obere) Kühlkörper 27 an der Oberseite 14 des zu kühlenden Gegenstands 11 anliegt und der (untere) Kühlkörper 28 an der Unterseite 15 des zu kühlenden Gegenstands 11. Die Oberseite 14 und die Unterseite 15 des zu kühlenden Gegenstands 11 können dabei beispielsweise jeweils mit dem Kühlkörper 27 bzw. 28 verschweißt sein.

Eine in dem Innenraum 18 angeordnete Innenwandung 19 des Grundkörpers 17 weist einen rahmenartigen, umlaufenden Kantenbereich mit einer umlaufenden Verbindungsnut 20 auf, in der der (umlaufende) Randabschnitt 21 des zu kühlenden Gegenstands 17 angeordnet ist. Im vorliegenden Fall ist der Randabschnitt 21 stoffschlüssig mit der Innenwandung 19 verbunden.

Zwischen dem zu kühlenden Gegenstand 11 und der Innenwandung 19 des Grundkörpers 10 befinden sich jeweils als umlaufende Dichtspalte 22 a und 22 b ausgebildete Dichtstellen, durch die ohne Abdichtung ungewollt das durch die Kühlkanäle 16 a und 16 b strömende Kühlmedium zwischen den zu kühlenden Gegenstand 11 und die Innenwandung 19 dringen könnte bzw. würde.

Der eine Dichtspalt 22 a ist dabei zwischen der Oberseite 14 des zu kühlenden Gegenstands 11 und der Oberseite 23 der Innenwandung 19 des Grundkörpers 17 angeordnet, der andere Dichtspalt 22 b ist zwischen der Unterseite 15 des zu kühlenden Gegenstands 11 und der Unterseite 24 der Innenwandung 19 des Grundkörpers 17 angeordnet.

Zur flüssigkeitsdichten Abdichtung der Dichtspalte 22 a und 22 b ist nun jeweils ein Dichtungssystem vorgesehen, das im vorliegenden Fall ein flächiges, rahmenartiges Dichtungsteil bzw. einen Dichtungsrahmen 25 a umfasst zur Abdichtung des Dichtspalts 22 a sowie einen Dichtungsrahmen 25 b zur Abdichtung des Dichtspalts 22 b. Es versteht sich, dass je nach Anwendung bzw. je nach Art der Dichtstelle auch andere Dichtungsteile eingesetzt werden können, die nicht rahmenartig ausgebildet sind.

Die Dichtungsteile bzw. Dichtungsrahmen 25 a, 25 b sind jeweils aus einem metallischen Werkstoff, vorzugsweise Aluminium, hergestellt bzw. bestehen aus diesem Werkstoff. Zur flüssigkeitsdichten Abdichtung überdecken sie den jeweiligen Dichtspalt 22 a bzw. 22 b und sind jeweils flüssigkeitsdicht mit der Innenwandung 19 des Grundkörpers 17 sowie dem jeweiligen Kühlkörper 27 bzw. 28 verbunden.

Konkret verfügt vorliegend ein innerer, umlaufender Rand- und Verbindungsbereich jedes Dichtungsrahmens 25 a, 25 b über eine jeweilige, streifenförmige Verbindungsfläche 26 a, die mit einer entsprechend gegenüberliegenden, umlaufenden, streifenförmigen Verbindungsfläche 27 a bzw. 28 a mit der Außenseite des jeweiligen Kühlkörpers 27 bzw. 28 flüssigkeitsdicht verbunden ist.

Ein äußerer, umlaufender Rand- und Verbindungsbereich jedes Dichtungsrahmens 25 a, 25 b verfügt über eine jeweilige streifenförmige Verbindungsfläche 26 b, die mit einer entsprechend gegenüberliegenden, umlaufenden, streifenförmigen Verbindungsfläche 23 a bzw. 24 a der Oberseite 23 der (Kunststoff-)Innenwandung 19 bzw. der Unterseite 24 der Innenwandung 19 flüssigkeitsdicht verbunden ist.

Für diese fluiddichte Verbindung der Oberseite 23 der (Kunststoff-)Innenwanderung 19 mit der äußeren (metallischen) Verbindungsfläche 26 b des Dichtungsrahmens 25 a bzw. zur Verbindung der Unterseite 24 der Innenwandung 19 mit der äußeren Verbindungsfläche 26 b des Dichtungsrahmens 25 b verfügt die jeweilige äußere Verbindungsfläche 26 b des jeweiligen Dichtungsrahmens 25 a, 25 b über eine insbesondere mittels eines chemischen und/oder physikalischen Mikrostrukturierungsverfahrens in die äußere Verbindungsfläche 26 b eingebrachte Nano- und/oder Mikrostrukturierung, insbesondere über eine Nanound/oder Mikrostrukturierung, die eine Oberflächenvergrößerung bewirkt und/oder Hinterschneidungen umfassende Vertiefungen und/oder Widerhaken aufweist.

Diese so bearbeitete Verbindungsfläche 26 b wird dann jeweils im Rahmen der Herstellung des Hybrid-Kühlbauteils 10 mit der (Kunststoff-)Innenwandung 19 verpresst.

Die fluiddichte Verbindung zwischen der jeweiligen inneren (metallischen) Verbindungsfläche 26 a einerseits und der jeweils gegenüberliegenden (metallischen) Verbindungsfläche 27 a bzw. 28 a des oberen Kühlkörpers 27 bzw. des unteren Kühlkörpers 28 wiederum wird vorliegend durch Laser(dicht)schweißen dieser beiden metallischen Oberflächen erreicht. Auch hier versteht es sich, dass auch andere Schweiß-Verbindungsverfahren denkbar sind, um diese fluiddichte Verbindung herzustellen.

Jeder Dichtungsrahmen 20 a, 25 b weist des Weiteren einen als Zwischenabschnitt gebildeten Verformungsabschnitt 29 auf, der zwischen dem äußeren und dem inneren Rand- bzw. Verbindungsabschnitt des jeweiligen Dichtungsrahmens 25 a bzw. 25 b angeordnet ist und der eine Dicke aufweist, vorliegend von wenigen mm, die eine elastische Verformung des Verformungsabschnitts 29 ermöglicht, sodass material- und/oder konstruktionsbedingte Unterschiede im Wärmausdehnungsverhalten der (Kunststoff-)Innenwandung 19 des Grundkörpers 17 und dem metallischen Werkstoff des Kühlkörpers 27 bzw. 28 ausgeglichen werden können.

**Bezugszeichenliste:**

| | | | |
|---|---|---|---|
| 10 | Hybrid-Kühlbauteil | 27 | oberer Kühlkörper |
| 11 | zu kühlender Gegenstand | 27 a | Verbindungsfläche oberer Kühlkörper |
| 12 | Zulauf | | |
| 13 | Ablauf | 28 | unterer Kühlkörper |
| 14 | Oberseite zu kühlender Gegenstand | 28 a | Verbindungsfläche unterer Kühlkörper |
| 15 | Unterseite zu kühlender Gegenstand | | |
| 16 a | Kühlkanal | 29 | Verformungsabschnitt |
| 16 b | Kühlkanal | | |
| 17 | Grundkörper Hybrid-Kühlbauteil | | |
| 18 | Innenraum | | |
| 19 | Innenwandung | | |
| 20 | Verbindungsnut Innenwandung | | |
| 21 | Randabschnitt zu kühlender Gegenstand | | |
| 22 a | Dichtspalt | | |
| 22 b | Dichtspalt | | |
| 23 | Oberseite Innenwandung | | |
| 23 a | Verbindungsfläche Oberseite | | |
| 24 | Unterseite Innenwandung | | |
| 24a | Verbindungsfläche Unterseite | | |
| 25 a | Dichtungsrahmen | | |
| 25 b | Dichtungsrahmen | | |
| 26 a | innere Verbindungsfläche Dichtungsrahmen | | |
| 26 b | äußere Verbindungsfläche Dichtungsrahmen | | |

## Patentansprüche

1. Verfahren zum Abdichten einer Dichtstelle (22 a, 22 b) in einem Hybrid-Kühlbauteil zum Abführen von Wärme von zu kühlenden Gegenständen, welche sich zwischen einer Kunststoffwandung eines ersten Bauteils (17) und einer vorzugsweise mit dieser Kunststoffwandung insbesondere stoff- und/oder formschlüssig verbundenen Wandung aus einem metallischen Werkstoff, insbesondere Aluminium, eines zweiten Bauteils (27, 28) befindet, wobei das erste Bauteil (17) und das zweite Bauteil (27, 28) Teil des Hybrid-Kühlbauteils sind, umfassend die folgenden Maßnahmen:
a) Bearbeiten einer ersten Verbindungsfläche eines insbesondere flächigen Dichtungsteils (25 a, 25 b) aus einem metallischen Werkstoff mit einem chemischen und/oder physikalischen Mikrostrukturierungsverfahren, sodass Nano- und/oder Mikrostrukturen in diese Verbindungsfläche eingebracht werden, insbesondere Nano- und/oder Mikrostrukturen, die eine Oberflächenvergrößerung bewirken und/oder Hinterschneidungen umfassende Vertiefungen aufweisen und/oder Widerhaken,
b) flüssigkeitsdichtes Überdecken der Dichtstelle (22 a, 22 b) mit dem Dichtungsteil (25 a, 25 b), wobei
b1) eine erste Verbindungsfläche des Dichtungsteils (25 a, 25 b) mit einer Verbindungsfläche der Kunststoffwandung des ersten Bauteils (17) flüssigkeitsdicht verpresst wird, und wobei
b2) eine zweite Verbindungsfläche des Dichtungsteils (25 a, 25 b) mit einer Verbindungsfläche der Wandung aus dem metallischen Werkstoff des zweiten Bauteils (27, 28) flüssigkeitsdicht verschweißt wird.

2. Vorrichtung mit einem ersten Bauteil (17) mit einer Kunststoffwandung und einem zweiten Bauteil (27, 28) mit einer bevorzugt mit der Kunststoffwandung des ersten Bauteils (17) verbundenen Wandung aus einem metallischen Werkstoff, wobei sich zwischen der Kunststoffwandung des ersten Bauteils (17) und der Wandung aus dem metallischen Werkstoff des zweiten Bauteils (27, 28) eine Dichtstelle (22 a, 22 b) befindet, wobei die Dichtstelle (22 a, 22 b) mit einem Dichtsystem flüssigkeitsdicht abgedichtet ist, das ein Dichtungsteil (25 a, 25 b) aus einem metallischen Werkstoff umfasst, das die Dichtstelle (22 a, 22 b) unter flüssigkeitsdichter Abdichtung derselben überdeckt, wobei es einerseits mit der Kunststoffwandung des ersten Bauteils (17) flüssigkeitsdicht verbunden ist, und andererseits mit der Wandung aus dem metallischen Werkstoff des zweiten Bauteils (27, 28) flüssigkeitsdicht verschweißt ist, wobei die Vorrichtung ein Hybrid-Kühlbauteil zum Abführen von Wärme von zu kühlenden Gegenständen ist, durch das ein Kühlmedium leitbar ist, das die Abwärme abführen kann, und wobei das erste Bauteil (17) mit der Kunststoffwandung ein Grundkörper aus Kunststoff des Hybrid-Kühlbauteils ist sowie das zweite Bauteil (27, 28) mit der Wandung aus dem metallischen Werkstoff ein Kühlkörper aus einem metallischen Werkstoff des Hybrid-Kühlbauteils, an den zu kühlende Gegenstände anordenbar sind und der unter Bildung der von dem Dichtungsteil (25 a, 25 b) überdeckten, insbesondere einen vorzugsweise umlaufenden Spalt bildenden Dichtstelle (22 a, 22 b) mit dem Grundkörper aus Kunststoff verbunden ist.

3. Vorrichtung gemäß Anspruch 2, **dadurch gekennzeichnet, dass** das Dichtungsteil (25 a, 25 b) ein Dichtungsrahmen ist, der den Dichtspalt überdeckt, derart, dass eine erste Verbindungsfläche des Dichtungsrahmens mit einer Verbindungsfläche der Kunststoffwandung des Grundkörpers des Hybrid-Kühlbauteils und eine zweite Verbindungsfläche des Dichtungsrahmens mit einer insbesondere umlaufenden Verbindungsfläche des Kühlkörpers des Hybrid-Kühlbauteils flüssigkeitsdicht verbunden ist.

4. Vorrichtung gemäß Anspruch 3, **dadurch gekennzeichnet, dass** die flüssigkeitsdichte Verbindung zwischen dem Dichtungsrahmen einerseits und der Kunststoffwandung des Grundkörpers andererseits umfasst, dass die Verbindungsfläche der Kunststoffwandung des Grundkörpers mit der ersten Verbindungsfläche des Dichtungsrahmens verpresst ist, wobei die erste Verbindungsfläche des Dichtungsrahmens über eine mittels eines chemischen und/oder physikalischen Mikrostrukturierungsverfahrens in die Verbindungsfläche eingebrachte Nano- und/oder Mikrostrukturierung verfügt, insbesondere eine Nano- und/oder Mikrostrukturierung, die eine Oberflächenvergrößerung bewirkt und/oder Hinterschneidungen umfassende Vertiefungen und/oder Widerhaken aufweist.

5. Vorrichtung gemäß Anspruch 2, 3 oder 4, **dadurch gekennzeichnet, dass** in dem Hybrid-Kühlbauteil mindestens ein zu kühlender Gegenstand angeordnet ist, der mit dem Kühlkörper unter Anlage an diesen verbunden ist.

6. Vorrichtung gemäß einem oder mehreren der vorhergehenden Ansprüche 2 bis 5, **dadurch gekennzeichnet, dass** eine Seite des Kühlkörpers eine Begrenzungsfläche eines Kühlmediumkanals des Hybrid-Kühlbauteils bildet, durch den Kühlmedium zum Abtransport von Abwärme eines oder des zu kühlenden Gegenstands leitbar ist, und dass eine andere Seite des Kühlkörpers eine Kühlfläche bildet, an der ein oder der zu kühlende Gegenstand anordenbar ist oder angeordnet ist.

7. Vorrichtung gemäß einem oder mehreren der vorhergehenden Ansprüche 2 bis 6, **dadurch gekennzeichnet, dass** der Dichtungsrahmen einen ersten, vorzugsweise äußeren Randabschnitt aufweist, an dem die erste Verbindungsfläche angeordnet ist, und einen zweiten, vorzugsweise inneren Randabschnitt, an dem die zweite Verbindungsfläche angeordnet ist, und dass zwischen diesen beiden Randabschnitten ein Verformungsabschnitt des Dichtungsrahmens angeordnet ist, der eine Dicke aufweist, die eine elastische Verformung desselben ermöglicht, die insbesondere material- und/oder konstruktionsbedingte Unterschiede im Wärmausdehnungsverhalten der Kunststoffwandung des Grundkörpers und dem metallischen Werkstoff des Kühlkörpers ausgleichen kann.

## Claims

1. Method for sealing a sealing point (22a, 22b) in a hybrid cooling component for dissipating heat from objects to be cooled, which is located between a plastic wall of a first component (17) and a wall made of a metallic material, in particular aluminum, of a second component (27, 28) that is preferably connected to said plastic wall, in particular by a substance-to-substance bonded manner and/or in a form-fit manner, wherein the first component (17) and the second component (27, 28) are part of the hybrid cooling component, comprising the following steps:
a) processing a first connection surface of a sealing part (25a, 25b), especially an areal sealing part (25a, 25b), made of a metallic material by a chemical and/or physical micro-structuring method, so that nano- and/or micro-structures are applied to the first connection surface, wherein the nano- and/or micro-structures cause a surface enlargement and/or have recesses which comprise undercuts and/or barbs,
b) covering the sealing point (22a, 22b) with the sealing part (25a, 25b) in a liquid-tight manner, wherein
b1) a first connection surface of the sealing part (25a, 25b) is pressed in a liquid-tight manner with a connection surface of the plastic wall of the first component (17), and wherein
b2) a second connection surface of the sealing part (25a, 25b) is welded in a liquid-tight manner to a connection surface of the wall made of the metallic material of the second component (27, 28).

2. Apparatus having a first component (17) with a plastic wall and a second component (27, 28) with a wall made of a metallic material, wherein the wall made of a metallic material is connected preferably to the plastic wall of the first component (17), wherein a sealing point (22 a, 22 b) is located between the plastic wall of the first component (17) and the wall made of the metallic material of the second component (27, 28), wherein the sealing point (22 a, 22 b) is sealed in a liquid-tight manner by a sealing system comprising a sealing part (25 a, 25 b) made of a metallic material, which covers the sealing point (22 a, 22 b) while sealing the sealing point (22 a, 22 b) in a liquid-tight manner,
wherein it is connected in a liquid-tight manner, on the one hand, to the plastic wall of the first component (17), and, on the other hand, is welded in a liquid-tight manner to the wall made of the metallic material of the second component (27, 28), wherein the apparatus is a hybrid cooling component for the dissipation of heat from objects to be cooled, through which a cooling medium capable of dissipating the waste heat can be conducted, and wherein the first component (17) with the plastic wall is a basic body made of plastic of the hybrid cooling component and the second component (27, 28) with the wall made of the metallic material is a cooling body made of a metallic material of the hybrid cooling component, to which objects to be cooled can be arranged, and which is connected to the basic body made of plastic while forming the sealing point (22a, 22b), preferably forming a circumferential gap, and which is covered by the sealing part (25a, 25b).

3. Apparatus according to claim 2, **characterized in that** the sealing part (25a, 25b) is a sealing frame which covers the sealing gap, such that a first connection surface of the sealing frame is connected in a liquid-tight manner to a connection surface of the plastic wall of the basic body of the hybrid cooling component, and a second connection surface of the sealing frame is connected in a liquid-tight manner to a, in particular, circumferential connection surface of the cooling body of the hybrid cooling component.

4. Apparatus according to claim 3, **characterized in that** the liquid-tight connection between the sealing frame, on the one hand, and the plastic wall of the basic body, on the other hand, comprises that the connection surface of the plastic wall of the basic body is pressed with the first connection surface of the sealing frame, wherein the first connection surface of the sealing frame has a nano- and/or micro-structuring which is applied by a chemical and/or physical micro-structuring method into the connection surface, in particular a nanoand/or micro-structuring that causes a surface enlargement and/or has recesses which comprise undercuts and/or barbs.

5. Apparatus according to claim 2, 3 or 4, **characterized in that** at least one object to be cooled is arranged within the hybrid cooling component and is connected to the cooling body so that it is in contact with it.

6. Apparatus according to one or more of the preceding claims 2 to 5, **characterized in that** one side of the cooling body forms a limitation surface of a cooling medium channel of the hybrid cooling component, through which a cooling medium is conductable for the evacuation of waste heat of the object to be cooled, and another side of the cooling body forms a cooling surface against which one or the object to be cooled can be arranged or is arranged.

7. Apparatus according to one or more of the preceding claims 2 to 6, **characterized in that** the sealing frame comprises a first, preferably outer, border section, on which the first connection surface is arranged, and a second, preferably inner, border section, on which the second connection surface is arranged, and **in that** between the two border sections a deformation section of the sealing frame is arranged, which has a thickness that allows for an elastic deformation of the deformation section, which is able to compensate, in particular, for material-related and/or design-related differences in the thermal expansion behaviour of the plastic wall of the basic body and the metallic material of the cooling body.

## Revendications

1. Procédé d'étanchéification d'une zone d'étanchéité (22a, 22b) dans un composant de refroidissement hybride destiné à évacuer la chaleur d'objets à refroidir, qui se trouve entre une paroi en plastique d'un premier composant (17) et une paroi en matériau métallique, en particulier en aluminium, d'un deuxième composant (27, 28), reliée de préférence à cette paroi en plastique notamment par adhérence et/ou par emboîtement, le premier composant (17) et le deuxième composant (27, 28) faisant partie du composant de refroidissement hybride, comprenant les mesures suivantes :
a) Usinage d'une première surface de jonction d'un élément d'étanchéité notamment plat (25a, 25b) en matériau métallique à l'aide d'un procédé de microstructuration chimique et/ou physique, de sorte que des nanostructures et/ou des microstructures soient introduites dans cette surface de raccordement, en particulier des nanostructures et/ou des microstructures qui provoquent un agrandissement de la surface supérieure et/ou présentent des creux comportant des contre-dépouilles et/ou des barbes,
b) recouvrement étanche aux liquides de la zone d'étanchéité (22a, 22b) par l'élément d'étanchéité (25a, 25b), dans lequel
b1) une première surface de jonction de l'élément d'étanchéité (25a, 25b) est pressée de manière étanche aux fluides contre une surface de jonction de la paroi en plastique du premier composant (17), et où
b2) une deuxième surface de raccordement de l'élément d'étanchéité (25a, 25b) est soudée de manière étanche aux fluides à une surface de raccordement de la paroi en matériau métallique du deuxième composant (27, 28).

2. Dispositif comprenant un premier composant (17) doté d'une paroi en plastique et un deuxième composant (27, 28) doté d'une paroi en matériau métallique, de préférence reliée à la paroi en plastique du premier composant (17), dans lequel, entre la paroi en plastique du premier composant (17) et la paroi en matériau métallique du deuxième composant (27, 28) se trouve une zone d'étanchéité (22a, 22b), ladite zone d'étanchéité (22a, 22b) étant rendue étanche aux liquides par un système d'étanchéité qui comprend un élément d'étanchéité (25a, 25b) en matériau métallique, laquelle recouvre la zone d'étanchéité (22a, 22b) en assurant son étanchéité aux fluides, cet élément étant d'une part relié de manière étanche aux fluides à la paroi en matière plastique du premier composant (17) et, d'autre part, soudé de manière étanche aux fluides à la paroi en matériau métallique du deuxième composant (27, 28), le dispositif étant un composant de refroidissement hybride destiné à évacuer la chaleur d'objets à refroidir, à travers lequel peut circuler un fluide de refroidissement capable d'évacuer la chaleur perdue, et le premier composant (17) à paroi en plastique constituant un corps de base en plastique du composant de refroidissement hybride, tandis que le deuxième composant (27, 28) avec la paroi en matériau métallique constitue un dissipateur thermique en matériau métallique de l'élément de refroidissement hybride, sur lequel des objets à refroidir peuvent être disposés et qui est relié au corps de base en plastique en formant la zone d'étanchéité (22a, 22b) recouverte par l'élément d'étanchéité (25a, 25b), formant notamment un interstice de préférence périphérique.

3. Dispositif selon la revendication 2, **caractérisé en ce que** l'élément d'étanchéité (25a, 25b) est un cadre d'étanchéité qui recouvre la fente d'étanchéité, de telle sorte qu'une première surface de liaison du cadre d'étanchéité soit reliée de manière étanche aux liquides à une surface de liaison de la paroi en plastique du corps de base de l'élément de refroidissement hybride, et qu'une deuxième surface de liaison du cadre d'étanchéité soit reliée de manière étanche aux liquides à une surface de liaison, notamment périphérique, du dissipateur thermique de l'élément de refroidissement hybride.

4. Dispositif selon la revendication 3, **caractérisé en ce que** la liaison étanche aux liquides entre le cadre d'étanchéité, d'une part, et la paroi en plastique du corps de base, d'autre part, comprend le fait que la surface de raccordement de la paroi en plastique du corps de base est pressée contre la première surface de raccordement du cadre d'étanchéité, la première surface de raccordement du cadre d'étanchéité présentant une nanostructure et/ou une microstructure introduite dans la surface de raccordement au moyen d'un procédé de microstructuration chimique et/ou physique, en particulier une nanostructure et/ou une microstructure qui provoque une augmentation de la surface et/ou qui présente des creux comportant des contre-dépouilles et/ou des barbes.

5. Dispositif selon la revendication 2, 3 ou 4, **caractérisé en ce que**, dans le composant de refroidissement hybride, est disposé au moins un objet à refroidir, qui est relié au dissipateur thermique en étant en contact avec celui-ci.

6. Dispositif selon une ou plusieurs des revendications précédentes 2 à 5, **caractérisé en ce qu'**un côté du dissipateur thermique forme une surface de délimitation d'un canal de fluide de refroidissement du composant de refroidissement hybride, à travers lequel un fluide de refroidissement peut être acheminé pour évacuer la chaleur résiduelle d'un ou de l'objet à refroidir, et **en ce qu'**un autre côté du dissipateur thermique forme une surface de refroidissement sur laquelle un ou l'objet à refroidir peut être disposé ou est disposé.

7. Dispositif selon l'une ou plusieurs des revendications 2 à 6 précédentes, **caractérisé en ce que** le cadre d'étanchéité présente une première partie de bord, de préférence extérieure, sur laquelle est disposée la première surface de liaison, et une deuxième partie de bord, de préférence intérieure, sur laquelle est disposée la deuxième surface de liaison, et **en ce qu'**entre ces deux parties de bord est disposée une partie déformable du cadre d'étanchéité, qui présente une épaisseur permettant une déformation élastique de celui-ci, capable notamment de compenser les différences de comportement à la dilatation thermique, dues notamment au matériau et/ou à la conception, entre la paroi en plastique du corps de base et le matériau métallique du dissipateur thermique.
